# EUROPEAN PATENT SPECIFICATION

(11) **EP 0 417 299 B1**
(45) Date of publication and mention of the grant of the patent: **14.01.1998**
(21) Application number: 90902690.8
(22) Date of filing: 06.02.1990
(51) Int. Cl.: H01L 23/427

(54) **ELECTRICALLY INSULATED HEAT PIPE-TYPE SEMICONDUCTOR COOLING DEVICE**
HALBLEITER-KÜHLANORDNUNG VOM ELEKTRISCH-ISOLIERTEN WÄRMEROHR-TYP
DISPOSITIF DE REFROIDISSEMENT DU TYPE A CALODUC ISOLE ELECTRIQUEMENT POUR ELEMENT SEMI-CONDUCTEUR

(30) Priority: 06.02.1989 JP 27024/89; 17.04.1989 JP 96685/89
(43) Date of publication of application: 20.03.1991
(73) Proprietor: THE FURUKAWA ELECTRIC CO., LTD., Tokyo 100 (JP)
(72) Inventor: MURASE, Takashi 34-5-5-505, Miyagaya Nishi-Ku, Kanagawa-Ken 220 (JP)
(74) Representative: Lehn, Werner, Dipl.-Ing.
(86) International application number: JP9000146
(87) International publication number: WO9009037

(56) References cited:
- GB-A- 2 127 330
- JP-A-62 293 654
- JP-A-62 293 655
- JP-U- 5 740 882
- PATENT ABSTRACTS OF JAPAN, vol. 12, no. 189 (E-616) 2 June 1988; & JP-A-62 293 655
- JOURNAL OF SPACECRAFT AND ROCKETS, vol. 12, no. 9, September 1975, New York US, pp. 517-518; K. GIER et al.: 'Flooding and dry-up limits of circumferential heat pipe grooves'
- PATENT ABSTRACTS OF JAPAN, vol. 12, no. 189 (E-616) 2 June 1988; & JP-A-62 293 654
- BBC-NACHRICHTEN, March 1966, Heidelberg DE, pp. 206-210; G. GAMMEL : 'Heat pipes zur Wärmeübertragung in Hochtemperatursystemen'
- PATENT ABSTRACTS OF JAPAN, vol. 13, no. 170 (M-817) 21 April 1989; & JP-A-10 003 497
- IBM TECHNICAL DISCLOSURE BULLETIN, vol. 13, no. 9, February 1971, New York US, pp. 2784-2785; S. CARBONE et al.: 'Metallic wick for a heat pipe'

## Description

### Technical Field

The present invention relates to an electrically insulating heat pipe semiconductor cooling apparatus having a plurality of heat pipes in each of which grooves capable of effectively operating as wicks to improve a radiation characteristic and a condensation characteristic are formed in the inner circumferential surface of each of a heating portion and a radiating portion.

### Background Art

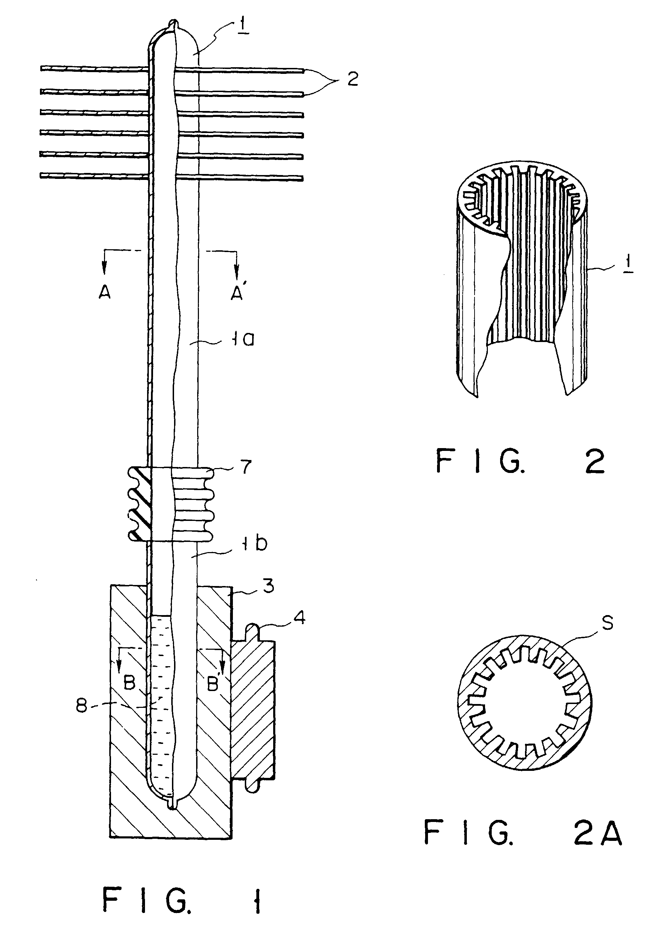

An insulating heat pipe is conventionally used as a cooling apparatus for a semiconductor such as a thyristor as disclosed in Published Unexamined Japanese Utility Model No. 57-40882. As shown in Fig. 1, this heat pipe is obtained by connecting first and second metal pipes 1a and 1b consisting of, e.g., copper, aluminum, or stainless steel via an electrically insulating cylinder 7, and sealing an electrically insulating operating fluid 8 such as freon or fluorocarbon, thereby forming an electrically insulating heat pipe 1.

This electrically insulating heat pipe is mainly used to cool a semiconductor such as a thyristor, and the second metal pipe 1b is inserted in and fixed to a metal block 3 normally mounting a semiconductor element 4. Heat generated by the semiconductor element 4 is input to the second metal pipe 1b through the metal block 3, transported to the first metal pipe la by an effect of the heat pipe 1, and naturally or forcibly cooled and radiated by fins 2 formed on the first metal pipe 1a.

In the above conventional electrically insulating heat pipe 1, however, the first and second metal pipes 1a and 1b are metal pipes having the same inner surface structure, and no grooves are formed therein or rectangular grooves S are linearly formed in the axial direction of the pipes, as shown in perspective and sectional views in Figs. 2 and 2A. The same inner surface structure of the pipes, e.g., the rectangular grooves serve to perform both boiling and condensation in the heat pipe.

Patent Abstracts of Japan, Vol. 12, No. 189 (E-616), 2 June 1988 and JP-A-62 293 654 discloses an electrically insulating heat pipe semiconductor cooling apparatus comprising:
a plurality of first metal pipes extending parallel to each other and each having open and closed ends, a plurality of second metal pipes extending parallel to each other and each having open and closed ends, electrically insulating pipes each connected between the open ends of the first and second metal pipes so that said first and second metal pipes communicate with each other, for forming heat pipes, a heat conductive block connected to said second metal pipes for mounting a semiconductor, radiating fins mounted on said first metal pipes, and an electrically insulating operating fluid sealed in said heat pipe, wherein V-shaped grooves extending parallel to the longitudinal axis of the heat pipe are formed on the inner circumferential surface of the heat pipe.

GB-A-2 127 330 discloses a heat pipe having at its inner circumferential surface longitudinal deep grooves separated by ridges. Shallow grooves are formed in the top surfaces of the ridges, such that the shallow grooves intersect the deep grooves. Burrs produced by the formation of the shallow grooves form bridges between adjacent ridges.

The Journal of Spacecraft and Rockets, Vol. 12, No. 9, September 1975, New York, U.S.A., pages 517 - 518 discloses a heat pipe having at its inner circumferential surface spiral grooves with a sharp vee profile.

Patent Abstracts of Japan, Vol. 12, No. 189 (E-616), 2 June 1988 and JP-A-62 293 655 discloses a heat pipe similar to the one disclosed in JP-A-62 293 654 but having longitudinally extending grooves of semicircular sectional shape.

The problem to be solved by the present invention is to provide an electrically insulating heat pipe semiconductor cooling apparatus having an excellent cooling efficiency and having a compact heat pipe.

The present invention is based on the finding that, in the prior art, the boiling (evaporation) and condensation of the operating fluid on the inner surface of the heat pipe cannot be individually performed in a satisfactory manner. In particular, the heat resistance is high at low heat input, resulting in poor cooling performance. Therefore, in the prior art, an apparatus is required to have large dimensions for obtaining a desired cooling performance.

An electrically insulating heat pipe semiconductor cooling apparatus according to the present invention comprises:
a plurality of first metal pipes arranged in a heat radiating portion of said apparatus and extending parallel to each other and each having open and closed ends, a plurality of second metal pipes arranged in a heat input portion of said apparatus and extending parallel to each other and each having open and closed ends, electrically insulating pipes each connected between the open ends of said first and second metal pipes so that said first and second metal pipes communicate with each other for forming heat pipes, a heat conductive block connected to said plurality of second metal pipes for mounting a semiconductor, radiating fins mounted on said plurality of first metal pipes, and an electrically insulating operating fluid sealed in said heat pipe, wherein first grooves are formed on an inner circumferential surface of each of said first metal pipes so as to be inclined in one direction with respect to a longitudinal axis of said heat pipe, and second and third grooves are formed on an inner surface of each of said second metal pipes so as to cross each other.

Therefore, according to the present invention, the structure of the first grooves in the heat radiating portion is different from the structure of the second and third grooves arranged in the heat input portion of the apparatus, such that optimum conditions are individually provided in the heat input portion and the heat radiating portion, respectively.

Preferred embodiments of the invention are indicated in the dependent claims 2 to 10.

### Brief Description of Drawings

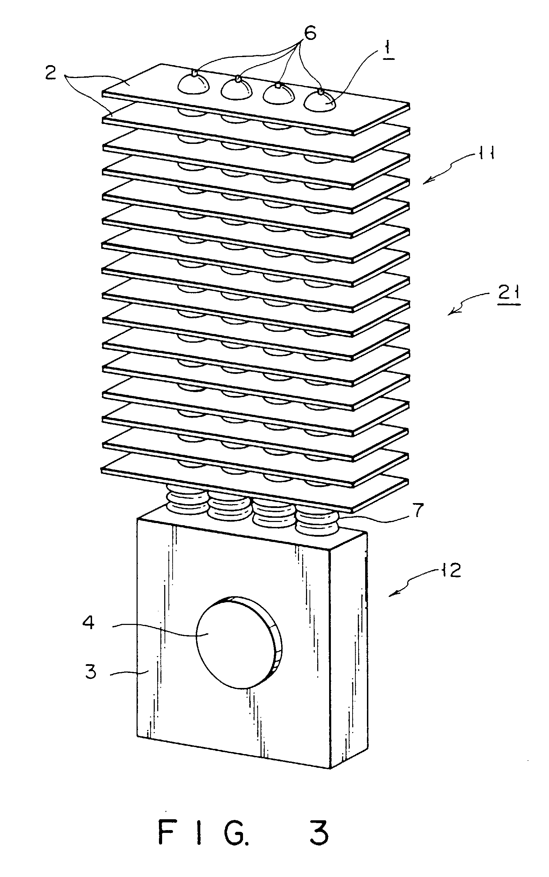

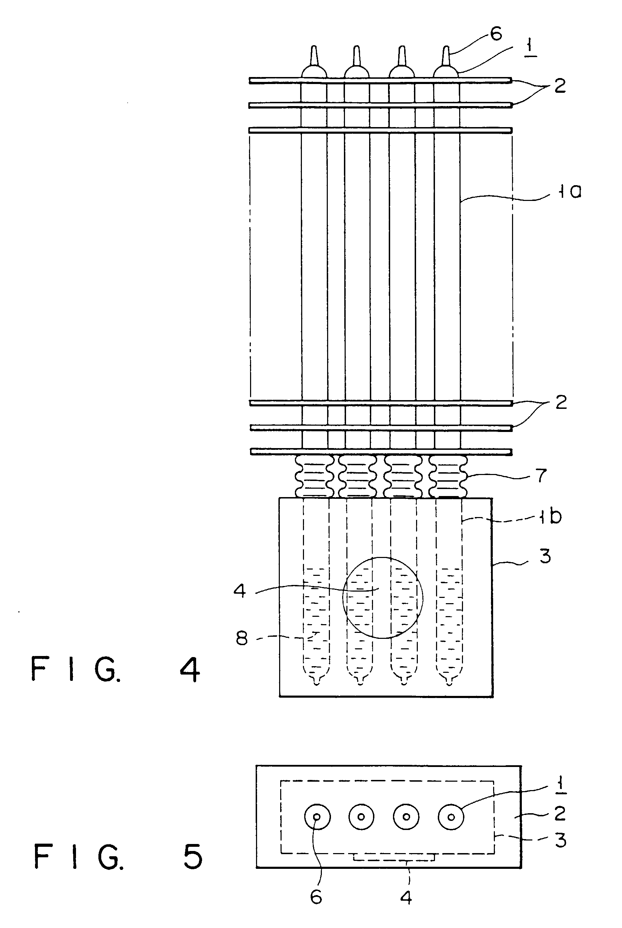

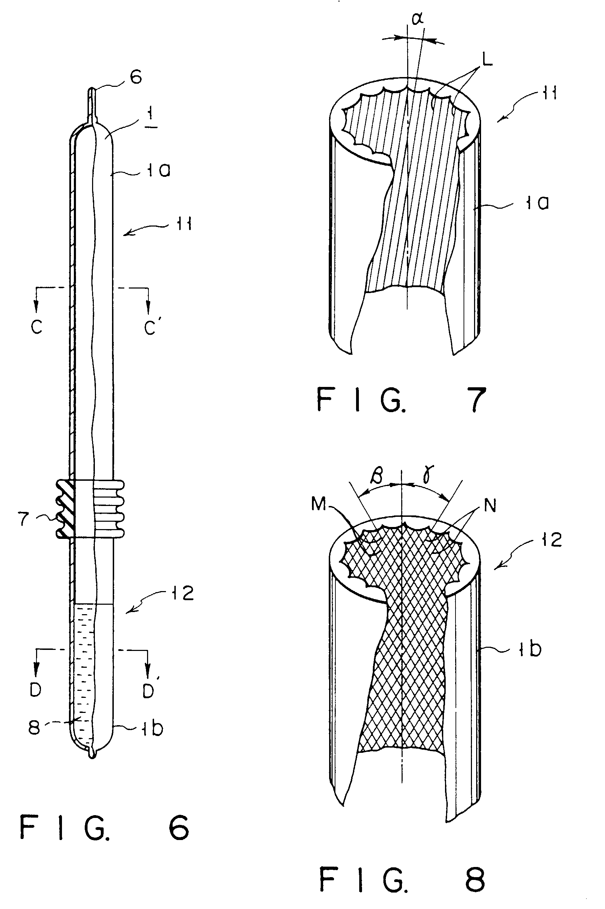

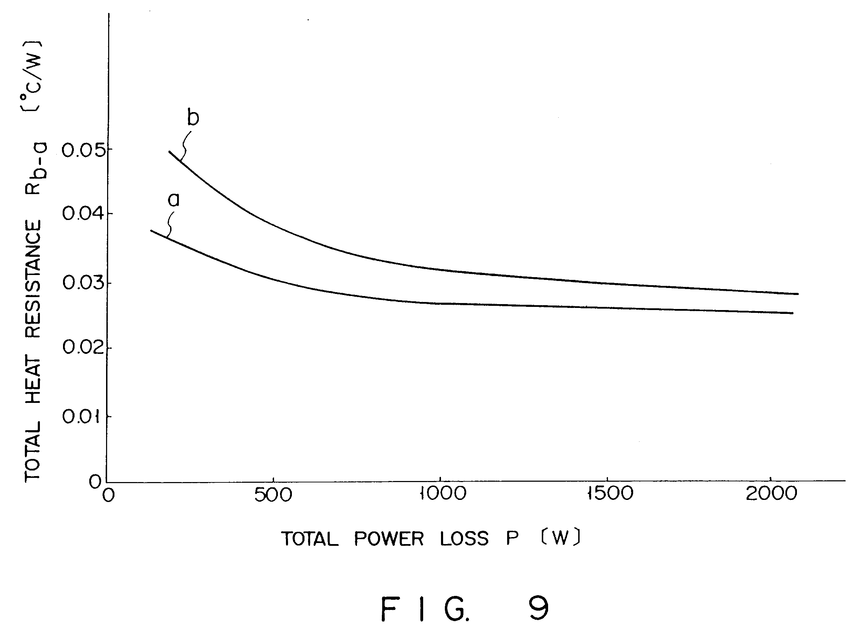

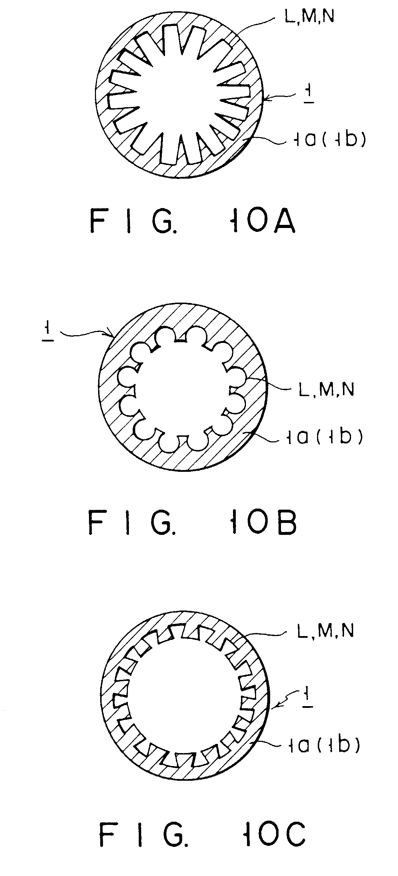

Fig. 1 is a partially cutaway side view showing a semiconductor cooling apparatus having a conventional heat pipe, Fig. 2 is a partially sectional perspective view showing the heat pipe shown in Fig. 1, Fig. 2A is a cross-sectional view showing one of sections taken along lines A - A' and B - B' of the heat pipe shown in Fig. 1, Fig. 3 is a perspective view showing an electrically insulating heat pipe semiconductor cooling apparatus, Fig. 4 is a front view showing the cooling apparatus shown in Fig. 3, Fig. 5 is a plan view thereof, Fig. 6 is a partially cutaway side view showing a heat pipe incorporated in an electrically insulating heat pipe semiconductor cooling apparatus, Figs. 7 and 8 are partially sectional perspective views showing first and second metal pipes shown in Fig. 6, Fig. 9 is a graph showing comparison between a cooling efficiency of the conventional heat pipe and that of the heat pipe according to the present invention, and Figs. 10A to 10C are cross-sectional views taken al, lines C - C' and D - D' of the heat pipe incorporated in the electrically insulating heat pipe semiconductor cooling apparatus and showing modifications of different grooves L, M, and N.

### Best Mode of Carrying Out the Invention

In order to explain the present invention in more detail, an embodiment of the present invention will be described below with reference to Figs. 3 to 8. In the following description of the embodiment, the same reference numerals as in the prior art shown in Fig. 1 denote the same parts and a detailed description thereof will be omitted.

Figs. 3 and 4 show an electrically insulating heat pipe semiconductor cooling apparatus 21 according to the embodiment of the present invention incorporating, e.g., four heat pipes 1.

The electrically insulating heat pipe semiconductor cooling apparatus 21 has a metal block 3 consisting of copper and capable of mounting a semiconductor 4. The four parallel heat pipes 1 having the same shape and quality project from the block 3. Electrically insulating cylinders 7 for electrical insulation are arranged in intermediate portions of the heat pipes 1, and a plurality of radiating fins 2 are fitted on their radiating portions.

The heat pipe 1 comprises a first metal pipe 1a having open and closed ends, a second metal pipe 1b having open and closed ends, and an aluminum electrically insulating cylinder 7 for preventing an electric leakage to the first metal pipe 1a. The first metal pipe 1a has a cylindrical shape having an outer diameter of 22 or 23 mm, and its closed end is tapered into a semispherical or conical shape by spinning processing. A nozzle 6 having a small hole is formed in the distal end portion of the closed end by spinning processing. As shown in Fig. 7, a plurality of first grooves L having a V-shaped section are formed on the inner circumferential surface of the first metal pipe 1a. The first groove L has a peak height of 0.3 mm and a pitch of 0.6 mm and is inclined through angle α = 5° in one direction with respect to the longitudinal axis of the pipe 1a. As shown in Fig. 8, the second metal pipe 1b has a cylindrical shape having the same diameter as that of the first metal pipe 1a, and its closed end is tapered into a semispherical or conical shape by spinning processing. Second and third grooves M and N having a V-shaped section are formed on the inner surface of the second metal pipe 1b. The grooves M and N have a peak height of 0.3 mm and a pitch 0.6 mm and cross each other to form angles β = 20° and γ = 20°, respectively, in opposite directions with respect to the longitudinal axis of the pipe 1b.

The aluminum electrically insulating cylinder 7 having a sealant (not shown) consisting of an Fe-Ni (42 wt%) alloy is assembled between the first and second metal pipes 1a and 1b manufactured as described above, and the open ends of the first and second metal pipes 1a and 1b are connected by the electrically insulating cylinder 7, thereby completing the electrically insulating heat pipe 1 (see Fig. 6). In this embodiment, the above sealant is incorporated in the electrically insulating cylinder 7 beforehand, and the sealant, the electrically insulating cylinder 7, and the first and second metal pipes 1a and 1b are connected by radio-frequency induction heating or the like.

A 120-mm long portion on the closed end side of each second metal pipe 1b is inserted in one of four blind holes (not shown) formed in one end face of the aluminum metal block 3 (length = 130 mm, width = 130 mm, and thickness = 30 mm) and is bonded therein by a soft wax material (not shown), thereby forming a heat input portion 12. An electrically insulating operating fluid 8 such as fluorocarbon is injected from the nozzle 6 of the heat pipe 1, and the metal block 3 is heated up to 50°C or more by a heater (not shown) to boil the operating fluid 8, thereby deaerating the heat pipe 1. Thereafter, the nozzle 6 at the distal end portion of the pipe 1 is caulked by a pressure jig, and the upper end portion of the nozzle 6 is closed by welding.

Note that the nozzle 6 need not be formed at the distal end portion on the side of a radiating portion 11 of the heat pipe 1 but may be formed at the distal end portion on the side of the heat input portion 12.

Finally, 100 aluminum fins 2 (48 mm x 200 mm and thickness = 0.5 mm) are fitted on the first metal pipe 1a portion (250 mm) at a pitch of 2.5 mm to form the radiating portion 11.

In the structure as described above, a bellows-like vibration damping member (not shown) is preferably arranged near the electrically insulating cylinder 7 of the first metal pipe 1a to prevent a damage to the connection portion between the first and second metal pipes 1a and 1b. Such a vibration damping member can be formed by bending a portion of the first metal pipe 1a or by mounting a bent elastic member on the first metal pipe 1a.

In this structure, heat generated by the semiconductor 4 such as a thyristor mounted on the metal block 3 is conducted to the metal block 3 constituting the heat input portion 12 and then to the second metal pipe 1b. Since a plurality each of second and third grooves M and N are inclined through 20° in opposite directions with respect to the longitudinal axis so as to cross each other, the area of the inner surface of the second metal pipe 1b is increased to be larger than that of the conventional structure. In addition, since generation of bubble cores is promoted in hollow portions formed near cross portions of the grooves M and N, evaporation and boiling characteristics are improved to improve a heat conduction characteristic on the inner surface of the heat input portion 12.

Vapor produced by evaporation rises toward the first metal pipe 1a and reaches the radiating portion 11. In the radiating portion 11, since a plurality of first grooves L are inclined through 5° in one direction with respect to the longitudinal axis, an area of the inner surface of the first metal pipe 1a is increased to be larger than that of the conventional structure, and condensation heat conduction of the operating fluid 8 is promoted by the grooves L to improve the radiation characteristic.

Latent heat generated by condensation is radiated in air from the plurality of the fins 2 fitted on the outer wall of the first metal pipe 1a in the radiating portion 11. In addition, the vapor which released heat is efficiently condensed and liquefied by the first grooves L formed on the inner circumferential surface of the radiating portion 11. The liquid is dropped in the gravity direction while it is turned around the pipe inner surface at angle α = 5° along the grooves L to wet the inner surface, and is returned to the heat input portion 12 of the second metal pipe 1b.

Note that the first grooves L are formed in one direction in order to smoothly return the liquid condensed by the grooves on the inner surface. Since cross grooves prevent a return of the condensed liquid, it is unsuitable to form cross grooves as formed in the boiling portion.

In this case, since the electrically insulating cylinder 7 is arranged between the first and second metal pipes 1a and 1b, only heat is conducted to the upper radiating portion 11. That is, since the radiating portion 11 is electrically insulated, a danger of an electric shock can be avoided. In addition, an electrically insulating liquid such as fluorocarbon is used as the operating fluid 8 to ensure safety. Furthermore, since the closed end of each of the first and second metal pipes 1a and 1b is tapered into a semispherical or conical shape, the grooves reach the end portion. As a result, an effective area is increased to be larger than that of a structure having a flat end portion, thereby increasing a heat efficiency as a heat pipe.

Fig. 9 shows comparison between cooling performance of the cooling apparatus 21 (using the inner surface groove pipes shown in Figs. 7 and 8) according to the embodiment described above and that of a conventional heat pipe cooling apparatus (using the inner surface groove pipe shown in Figs. 2 and 2A) in which rectangular grooves are formed in the inner surfaces of both the first and second metal pipes 1a and 1b.

In this performance test, a flat thyristor 4 having a post diameter of 75 mm was fixed by clamping between the metal blocks 3 of a set of two cooling apparatuses. While the vertically set apparatuses were cooled with wind at a front surface wind velocity of 3 m/s, the thyristor 4 was operated, and a power loss of 200 to 2,000 W was applied to check heating performance (heat resistance). In Fig. 9, the abscissa indicates a heat amount (total power loss) P [W] generated by the thyristor, and the ordinate indicates a total heat resistance R_{b-a} of a set of the two cooling apparatuses. The heat resistance R_{b-a} is represented by the following equation:
- R_{b-a} =: (T_{b} - Tₐ)/P
- R_{b-a};: a heat resistance between a metal block surface and air [°C/W]
- T_{b};: a thyristor mounting metal block surface temperature [°C]
- Tₐ ;: an environmental temperature [°C]
- P ;: a power loss from a thyristor [W]

As shown in Fig. 9, it was confirmed that the total heat resistance was reduced by about 25% when a power loss from the thyristor 4 was 500 W and about 15% when the power loss was 1,000 W (i.e., the cooling performance was improved) by the cooling apparatus of the present invention as compared with the conventional cooling apparatus.

As is apparent from Fig. 9, it was found that the heat resistance R_{b-a} [°C/W] of this embodiment (curve a) was reduced to be lower than that of the conventional apparatus (curve b), i.e., the radiating performance was apparently improved (especially in a low heat and low power loss state at 500 W or less, the heat resistance was reduced).

The present invention is not limited to the above embodiment. For example, as shown in Figs. 10A to 10C, a plurality of first, second, and third grooves L, M, and N formed on the inner circumferential surfaces of the first and second metal pipes 1a and 1b may have a rectangular, semicircular, or trapezoidal sectional shape provided that the grooves are inclined through an angle within a predetermined range with respect to the longitudinal axis of the pipe. When the inclination angle of the first grooves L formed on the inner surface of the first metal pipe 1a falls within the range of α = 2° to 10°, a suitable condensation characteristic can be obtained. When the inclination angles of the second and third grooves M and N formed on the inner surface of the second metal pipe 1b fall within the ranges of β = 2° to 45° and γ = 2° to 45° (cross angle θ = 4° to 90°), a suitable boiling characteristic can be obtained. Although the first and second metal pipes 1a and 1b have the same diameter, the boiling characteristic can be improved by increasing the diameter of the second metal pipe 1b serving as the heat input portion 12 to be larger than that of the first metal pipe 1a. In addition, the sectional shape of the first and second metal pipes is not limited to a circle but may be another shape such as an elipse or a rectangle. Furthermore, according to the cooling apparatus of this embodiment, even if the semiconductor 4 such as a thyristor is directly mounted on the surface of the metal block 3, not a potential but only heat of the semiconductor 4 is conducted to the radiating portion 11 since the radiating portion 11 is electrically insulated by the electrically insulating cylinder 7 at an intermediate portion of the heat pipe 1, thereby preventing a danger such as an electric shock. The electrically insulating heat pipe semiconductor cooling apparatus having the above structure can be set either vertically or horizontally. Even when the apparatus is set horizontally, a plurality of grooves formed in the heat pipe 1 can effectively serve as wicks to promote a return of the operating fluid 8, thereby improving the boiling and condensation characteristics.

As a result, a cooling efficiency can be improved, and the size of equipment can be decreased. Industrial Applicability

As described above, the electrically insulating heat pipe semiconductor cooling apparatus according to the present invention uses a heat pipe having pipe inner surface shapes improved to be better than that of a conventional heat pipe in both heat input and radiating portions. Therefore, since boiling and condensation characteristics are largely improved to promote a cooling efficiency, a power semiconductor such as a thyristor can be effectively cooled. In particular, high boiling and condensation characteristics can be achieved even in a low heat input state.

## Claims

1. An electrically insulating heat pipe semiconductor cooling apparatus (21) which comprises:
a plurality of first metal pipes (la) arranged in a heat radiating portion (11) of said apparatus (21) and extending parallel to each other and each having open and closed ends;
a plurality of second metal pipes (1b) arranged in a heat input portion (12) of said apparatus (21) and extending parallel to each other and each having open and closed ends;
electrically insulating pipes (7) each connected between the open ends of said first and second metal pipes (1a, 1b) so that said first and second metal pipes (1a, 1b) communicate with each other for forming heat pipes (1);
a heat conductive block (3), connected to said plurality of second metal pipes (1b), for mounting a semiconductor;
radiating fins (2) mounted on said plurality of first metal pipes (1a); and
an electrically insulating operating fluid (8) sealed in said heat pipe (1),
characterized in that first grooves (L) are formed on an inner circumferential surface of each of said first metal pipes (1a) so as to be inclined in one direction with respect to a longitudinal axis of said heat pipe (1), and second (M) and third (N) grooves (M, N) are formed on an inner surface of each of said second metal pipes (1b) so as to cross each other.

2. An apparatus according to claim 1, wherein said first grooves (L) are inclined through an angle of 2° to 10° with respect to the longitudinal axis.

3. An apparatus according to claim 1 or 2, wherein said second and third grooves (M, N) cross each other at an angle of 4° to 90°.

4. An apparatus according to claim 3, wherein said second grooves (M) cross the longitudinal axis of said heat pipe (1) at an angle of 2° to 45°, and said third grooves (N) cross the longitudinal axis of said heat pipe (1) at an angle of 2° to 45°.

5. An apparatus according to claim 1, wherein at least one of said first (L), second (M), and third (N) grooves (L, M, N) has a V-shaped sectional shape.

6. An apparatus according to claim 1, wherein at least one of said first (L), second (M), and third (N) grooves (L, M, N) has a rectangular sectional shape.

7. An apparatus according to claim 1, wherein at least one of said first (L), second (M), and third (N) grooves (L, M, N) has a semicircular sectional shape.

8. An apparatus according to claim 1, wherein at least one of said first (L), second (M), and third (N) grooves (L, M, N) has a trapezoidal sectional shape.

9. An apparatus according to claim 1, wherein the closed end of each of said first metal pipe (1a) has a tapered portion having a circular sectional shape, said tapered portion having a nozzle (6) formed at a distal end thereof.

10. An apparatus according to claim 1, wherein the closed end of each of said second metal pipes (1b) has a tapered portion having a circular sectional shape, said tapered portion having a nozzle (6) formed at a distal end thereof.

## Patentansprüche

1. Elektrisch isolierende WärmeübertragungsrohrHalbleiterkühlvorrichtung (21), welche aufweist:
mehrere erste Metallrohre (1a), die in einem Wärmeabstrahlabschnitt (11) der Vorrichtung (21) angeordnet sind, parallel zueinander verlaufen, und jeweils ein geöffnetes und ein geschlossenes Ende aufweisen;
mehrere zweite Metallrohre (1b), die in einem Wärmeeingangsabschnitt (12) der Vorrichtung (21) angeordnet sind, parallel zueinander verlaufen, und jeweils ein geöffnetes und ein geschlossenes Ende aufweisen;
elektrisch isolierende Rohre (7), die jeweils zwischen den geöffneten Enden der ersten und zweiten Metallrohre (1a, 1b) angeordnet sind, so daß die ersten und zweiten Metallrohre (1a, 1b) miteinander zur Ausbildung von Wärmeübertragungsrohren (1) in Verbindung stehen;
einen wärmeleitenden Block (3), der mit den mehreren zweiten Metallrohren (1b) verbunden ist, um einen Halbleiter anzubringen;
Abstrahlrippen (2), die auf den mehreren ersten Metallrohren (1a) angeordnet sind; und
ein elektrisch isolierendes Betriebsfluid (8), welches abgedichtet in dem Wärmeübertragungsrohr (1) enthalten ist,
dadurch **gekennzeichnet**, daß erste Nuten (L) auf einer Innenoberfläche jedes der ersten Metallrohre (la) so vorgesehen sind, daß sie in einer Richtung in Bezug auf eine Längsachse des Wärmeübertragungsrohrs (1) geneigt angeordnet sind, und zweite (M) und dritte (N) Nuten (M, N) auf einer Innenoberfläche jedes der zweiten Metallrohre (1b) so vorgesehen sind, daß sie einander kreuzen.

2. Vorrichtung nach Anspruch 1,
bei welcher die ersten Nuten (L) um einen Winkel von 2 ° bis 10 ° in Bezug auf die Längsachse geneigt angeordnet sid.

3. Vorrichtung nach Anspruch 1 oder 2,
bei welcher die zweiten und dritten Nuten (M, N) einander in einem Winkel von 4 ° bis 90 ° kreuzen.

4. Vorrichtung nach Anspruch 3,
bei welcher die zweiten Nuten (M) die Längsachse des Wärmeübertragungsrohrs (1) in einem Winkel von 2 ° bis 45 ° kreuzen, und die dritten Nuten (N) die Längsachse des Wärmeübertragungsrohrs (1) in einem Winkel von 2 ° bis 45 ° kreuzen.

5. Vorrichtung nach Anspruch 1,
bei welcher zumindest eine der ersten (L), zweiten (M) und dritten (N) Nuten (L, M, N) im Querschnitt V-förmig ist.

6. Vorrichtung nach Anspruch 1,
bei welcher zumindest eine der ersten (L), zweiten (M) und dritten (N) Nuten (L, M, N) im Querschnitt rechteckförmig ist.

7. Vorrichtung nach Anspruch 1,
bei welcher zumindest eine der ersten (L), zweiten (M) und dritten (N) Nuten (L, M, N) im Querschnitt halbkreisförmig ist.

8. Vorrichtung nach Anspruch 1,
bei welcher zumindest eine der ersten (L), zweiten (M) und dritten (N) Nuten (L, M, N) im Querschnitt trapezförmig ist.

9. Vorrichtung nach Anspruch 1,
bei welcher das geschlossene Ende jedes der ersten Metallrohre (1a) einen verjüngten Abschnitt aufweist, der im Querschnitt kreisförmig ist, wobei der verjüngte Abschnitt an seinem entfernten Ende mit einer Düse (6) versehen ist.

10. Vorrichtung nach Anspruch 1,
bei welcher das geschlossene Ende jedes der zweiten Metallrohre (1b) einen verjüngten Abschnitt aufweist, der im Querschnitt kreisförmig ist, und der verjüngte Abschnitt mit einer Düse (6) an seinem entfernten Ende versehen ist.

## Revendications

1. Appareil (21) de refroidissement pour semiconducteur du type à caloduc électriquement isolant, comprenant:
une pluralité de premiers tubes métalliques (1a) agencés dans une portion rayonnant de la chaleur (11) dudit appareil (21), s'étendant parallèlement les uns aux autres et ayant chacun des extrémités ouverte et. fermée;
une pluralité de deuxièmes tubes métalliques (1b) agencés dans une portion d'apport de chaleur (12) dudit appareil (21), s'étendant parallèlement les uns aux autres et ayant chacun des extrémités ouverte et fermée;
des tubes électriquement isolants (7) connectés chacun entre les extrémités ouvertes desdits premiers et deuxièmes tubes métalliques (1a, 1b) de sorte que lesdits premiers et deuxièmes tubes métalliques (1a, 1b) communiquent les uns avec les autres pour former des caloducs (1);
un bloc conducteur de la chaleur (3), connecté à ladite pluralité de deuxièmes tubes métalliques (1b), destiné au montage d'un semiconducteur;
des ailettes rayonnantes (2) montées sur ladite pluralité de premiers tubes métalliques (1a); et
un fluide moteur (8) électriquement isolant enfermé hermétiquement dans ledit caloduc (1),
caractérisé en ce que des premières cannelures (L) sont formées sur une surface circonférentielle interne de chacun desdits premiers tubes métalliques (1a) de manière à être inclinées selon une direction par rapport à un axe longitudinal dudit caloduc (1), et en ce que des deuxièmes (M) et troisièmes (N) cannelures (M, N) sont formées sur une surface interne de chacun desdits deuxièmes tubes métalliques (1b) de manière à se croiser.

2. Appareil selon la revendication 1, dans lequel lesdites premières cannelures (L) sont inclinées d'un angle de 2° à 10° par rapport à l'axe longitudinal.

3. Appareil selon la revendication 1 ou 2, dans lequel lesdites deuxièmes et troisièmes cannelures (M, N) se croisent à un angle de 4° à 90°.

4. Appareil selon la revendication 3, dans lequel lesdites deuxièmes cannelures (M) croisent l'axe longitudinal dudit caloduc (1) à un angle de 2° à 45°, et lesdites troisièmes cannelures (N) croisent l'axe longitudinal dudit caloduc (1) à un angle de 2° à 45°.

5. Appareil selon la revendication 1, dans lequel au moins l'une desdites premières (L), deuxièmes (M), et troisièmes (N) cannelures (L, M, N) a une forme en V en section transversale.

6. Appareil selon la revendication 1, dans lequel au moins l'une desdites premières (L), deuxièmes (M), et troisièmes (N) cannelures (L, M, N) a une forme rectangulaire en section transversale.

7. Appareil selon la revendication 1, dans lequel au moins l'une desdites premières (L), deuxièmes (M), et troisièmes (N) cannelures (L, M, N) a une forme semi-circulaire en section transversale.

8. Appareil selon la revendication 1, dans lequel au moins l'une desdites premières (L), deuxièmes (M), et troisièmes (N) cannelures (L, M, N) a une forme trapézoïdale en section transversale.

9. Appareil selon la revendication 1, dans lequel l'extrémité fermée de chacun desdits premiers tubes métalliques (la) a une portion conique ayant une forme circulaire en section transversale, ladite portion conique ayant une buse (6) formée à une extrémité distale de celle-ci.

10. Appareil selon la revendication 1, dans lequel l'extrémité fermée de chacun desdits deuxièmes tubes métalliques (1b) a une portion conique ayant une forme circulaire en section transversale, ladite portion conique ayant une buse (6) formée à une extrémité distale de celle-ci.
